(19) Europäisches Patentamt
European Patent Office
Office européen des brevets

(11) **EP 3 608 356 A1**

(12) **EUROPEAN PATENT APPLICATION**
published in accordance with Art. 153(4) EPC

(43) Date of publication:
**12.02.2020 Bulletin 2020/07**

(51) Int Cl.:
***C08J 9/28*** *(2006.01)*       ***H05K 1/03*** *(2006.01)*

(21) Application number: **18781239.1**

(22) Date of filing: **06.04.2018**

(86) International application number:
**PCT/JP2018/014710**

(87) International publication number:
**WO 2018/186486 (11.10.2018 Gazette 2018/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.04.2017   JP 2017075675**
**25.01.2018   JP 2018010675**

(71) Applicant: **Nitto Denko Corporation**
**Ibaraki-shi, Osaka 567-8680 (JP)**

(72) Inventors:
• **NAKAMURA, Masayoshi**
**Ibaraki-shi**
**Osaka 567-8680 (JP)**

• **HODONO, Masayuki**
**Ibaraki-shi**
**Osaka 567-8680 (JP)**
• **ITO, Takahiko**
**Ibaraki-shi**
**Osaka 567-8680 (JP)**
• **NAGAOKA, Naoki**
**Ibaraki-shi**
**Osaka 567-8680 (JP)**
• **HISHIKI, Tomoaki**
**Ibaraki-shi**
**Osaka 567-8680 (JP)**

(74) Representative: **Gill Jennings & Every LLP**
**The Broadgate Tower**
**20 Primrose Street**
**London EC2A 2ES (GB)**

(54) **FILM FOR MILLIMETER-WAVE ANTENNA**

(57)     Provided is a porous low-dielectric polymer film which has a low dielectric constant at high millimeter-wave frequencies to fulfill utility as a sheet for a millimeter-wave antenna, and provides excellent circuit board processability. The porous low-dielectric polymer film is made of a polymer material and formed with fine pores dispersed therein, wherein the film has a porosity of 60% or more, and the pores have an average pore diameter of 50 μm or less, and wherein a porous structure of the film is a closed-cell structure.

FIG.3

**Description**

TECHNICAL FIELD

The present invention relates to a low-dielectric porous polymer film. In particular, the present invention relates to a low-dielectric porous polymer film useful as a sheet for a millimeter-wave antenna.

BACKGROUND ART

A millimeter wave is an electromagnetic wave having a frequency of 30 GHz to 300 GHz, which is called like that because the wavelength thereof is in a millimeter order (1 mm to 10 mm). From a viewpoint that an electromagnetic wave having a frequency lower than the millimeter wave, such as a microwave, is generally not much influenced by rain or the like, it have been utilized in broadcasting by television, radio and the like, mobile phone communications, and long-range wireless communications. In contrast, the millimeter wave has difficulty in being used in long-range wireless communications, because it undergoes attenuation due to rain, and attenuation due to resonance absorption caused by oxygen or water molecules in the air, or the like.

On the other hand, because of a shorter wavelength, the millimeter wave is capable of transmitting a larger amount of data at one time. Further, in a case where the millimeter wave is applied to imaging techniques, resolution is enhanced, so that it is expected to obtain an image having a higher definition than that obtainable by microwave imaging. Therefore, the millimeter wave is expected to be used for short-range wireless communications and by a radar to be mounted to a vehicle such as an automobile.

An antenna for use in a millimeter-wave communication module (millimeter-wave antenna) typically has a structure in which an array of antenna electrodes formed of wires is provided on a resin or ceramic substrate. A power loss of an antenna is proportional to wiring loss and antenna radiation loss, wherein the wiring loss and the antenna radiation loss are proportional, respectively, to the square root of the dielectric constant of the substrate, and the dielectric constant of the substrate. Therefore, in order to enhance the gain of the millimeter-wave antenna to increase a millimeter-wave communication range as long as possible, it is effective to lower the dielectric constant of the substrate.

The dielectric constant of a plastic material such as a resin is generally determined by a molecular frame. Thus, as an approach to lower the dielectric constant, it is conceivable to modify the molecular frame. However, even in polyethylene and polytetrafluoroethylene having relatively low dielectric constants, the dielectric constants are, respectively, about 2.3 and about 2.1, so that there are limits to lower the dielectric constant of a plastic material by means of control of the molecular frame thereof. Moreover, the modification of the molecular frame is likely to lead to a problem that physical properties, such as strength and linear expansion coefficient, of a film formed using the plastic material undesirably change.

A polyimide resin is widely used as a material for components or elements requiring reliability, e.g., electronic or electric components and devices such as a circuit board, from a viewpoint of its features such as high insulation property, dimensional stability, formability and lightweight property. Particularly, in recent years, along with improvements in performance and functionality of electric or electronic devices, the electric or electronic devices are required to achieve faster transmission of information, and elements for use in these devices are also required to comply with such higher-speed transmission. With regard to polyimide to be used for such devices or elements, it is attempted to lower the dielectric constant and the dielectric loss tangent thereof so as to provide electric properties complying with the higher-speed transmission.

As another approach to lower the dielectric constant, there have been proposed various methods intended to porosify a plastic material to control the dielectric constant in accordance with the porosity of the resulting porous plastic material, based on the fact that the dielectric constant of air is 1.

For example, JP H09-100363A discloses a heat-resisting, low-dielectric, plastic insulating film usable in a printed-wiring board of an electronic device or the like and for slot insulation in a rotary machine or the like, wherein the film comprises porous plastic having a porosity of 10 vol% or more, and has a heatproof temperature of 100°C or more and a dielectric constant of 2.5 or less.

Further, JP 2012-101438A discloses a laminate of a metal foil layer and a polyimide layer including a porous polyimide layer, which is useful as a board for a printed-wiring board, wherein the polyimide layer comprises a non-porous polyimide layer, a porous polyimide layer and a non-porous polyimide layer which are laminated on one surface of the metal foil layer in this order, and wherein a total thickness of the polyimide layers is from 10 to 500 $\mu$m, and the thickness of the porous polyimide layer falls within the range of 10% to 90% with respect to the total thickness of the polyimide layers.

Examples of a conventional method for obtaining a porous polymer include a dry method and a wet method. As the dry method, there have been known a physical foaming method and a chemical foaming method.

The physical foaming method comprises: dispersing, as a foaming agent, a low-boiling-point solvent such as chlorofluorocarbon or hydrocarbon, over a polymer to prepare a mixture; and then heating the mixture to volatilize the foaming agent to thereby obtain a porous body.

On the other hand, the chemical forming method comprises: adding a foaming agent to a polymer to prepare a mixture; and thermally decomposing the mixture to form cells by means of gas generated through the thermal decomposition to thereby obtain a foamed body.

Foaming based on the physical approach involves various environmental problems such as hazardous properties of and destruction of the ozone layer by a substance used as the foaming agent. Moreover, generally, the physical approach is suitably used to obtain a foamed body having a cell diameter of several ten $\mu$m or more, but has a difficulty in obtaining a foamed body having cells with fine and uniform diameters.

On the other hand, in foaming based on the chemical approach, after completion of the foaming, a residue of the foaming agent having caused the gas generation is highly likely to be left inside the foamed body. Thus, particularly in use for electronic components highly requiring a low contamination property, contamination by a corrosive gas or impurities is likely to become a problem.

Further, as a method for obtaining a porous body having a small cell diameter and a high cell density, there has been proposed a method comprising: dissolving an inert gas such as nitrogen gas or carbon dioxide gas, in a polymer at a high pressure; and then, after releasing the pressure, heating the polymer up to around a glass-transition temperature or a softening temperature thereof to thereby form cells. This foaming method is designed to form nuclei from a thermodynamically instable state, and allow the formed nuclei to expand and grow to thereby form cells, so that it has an advantage of being able to obtain a previously-unattainable microporous foamed body.

For example, JP 2001-081225A discloses a production method for a porous body usable as, e.g., a circuit board of an electronic device or the like, wherein the porous body has fine cells and exhibits a low dielectric constant and a heat-resisting property. The production method comprises removing, from a polymer composition having a microphase-separated structure in which non-continuous phases having an average diameter of less than 10 $\mu$m are dispersed over a continuous phase of a polymer, a component constituting the non-continuous phase, by at least one operation selected from vaporization and decomposition, and an extraction operation, to thereby porosify the polymer composition, wherein liquefied carbon dioxide or carbon dioxide being in a supercritical state is used as an extraction solvent for the component constituting the non-continuous phase.

Further, JP 2002-146085A discloses a production method for a porous polyimide usable as a circuit board of an electronic device or the like, wherein the porous polyimide has a fine cell structure and exhibits a heat-resisting property. The method comprises: removing, from a polymer composition having a microphase-separated structure in which non-continuous phases composed of a dispersible compound B and having an average diameter of less than 10 $\mu$m are dispersed over a continuous phase composed of a polyimide precursor A, the dispersible compound B; and then converting the polyimide precursor A into a polyimide to thereby produce the porous polyimide, wherein an interaction parameter $\chi_{AB}$ between the polyimide precursor A and the dispersible compound B satisfies the following relationship: $3 < \chi_{AB}$, and wherein supercritical carbon dioxide is used as an extraction solvent for the dispersible compound B.

CITATION LIST

[Patent Document]

Patent Document 1: JP H09-100363A

Patent Document 2: JP 2012-101438A

Patent Document 3: JP 2001-081225A

Patent Document 4: JP 2002-146085A

SUMMARY OF INVENTION

[Technical Problem]

A conventional technique utilizing a porous plastic material is capable of achieving a certain degree of lowering of the dielectric constant, but has a problem in circuit board processability (processability of a circuit board as a product).

Specifically, in a process of producing an antenna circuit board, when a workpiece is subjected to boring using a drill or laser, and then to plating, there can arise a problem that a plating solution intrudes into pores from portions thereof exposed to the outside by the boring and Cu is precipitated in the pores (plating solution penetration), or in a process of laminating a low-dielectric material to a board, hot pressing can give rise to a problem of collapse of pores (pressing resistance (resistance to pressing)).

It is an object of the present invention to provide a low-dielectric porous polymer film which has a low dielectric constant at high millimeter-wave frequencies to fulfill utility as a sheet for a millimeter-wave antenna, and provides excellent circuit board processability.

[Solution to Technical Problem]

As a result of diligent researches for solving the above problems, the inventers found that the above problems can be solved by a low-dielectric porous polymer film which is made of a polymer material and formed with fine pores dispersed therein, wherein the film has a given porosity, and the pores have a given average pore diameter, and wherein a porous structure of the film is a closed-cell structure, and have finally reached the present invention.

Specifically, the present invention provides a porous low-dielectric polymer film which is made of a polymer material and formed with fine pores dispersed therein, wherein the film has a porosity of 60% or more, and the pores have an average pore diameter of 50 $\mu$m or less, and wherein a porous structure of the film is a closed-cell structure.

In the film according to the present invention, the porosity is preferably 70% or more. Further, in the film according to the present invention, the average pore diameter is preferably 30 $\mu$m or less, more preferably 10 $\mu$m or less.

In the film according to the present invention, the pores have a pore diameter distribution with a full width at half maximum which is preferably 15 $\mu$m or less, more preferably 10 $\mu$m or less.

The film according to the present invention may have a porous structure in which closed pores account for 80% or more of the entire pores, or may have a porous structure having only closed pores.

The film according to the present invention have a porous structure whose liquid penetration length is preferably 500 $\mu$m or less, more preferably 300 $\mu$m or less, as measured after immersing a cut surface of the film in a penetrant for 5 minutes.

As one example, for forming the porous structure of the film according the present invention into the closed-cell structure, it is desirable to use polyoxyethylene dimethyl ether as a porosifying agent (pore-forming agent) for use in production of the film, and, as needed, a nucleation agent such as a polytetrafluoroethylene (PTFE) powder.

The film according to the present invention has a dielectric constant as measured at 10 GHz, which is preferably 2.0 or less, more preferably 1.5 or less.

In the film according to the present invention, the polymer or a precursor of the polymer is preferably soluble in an organic solvent such as N-methylpyrrolidone (NMP).

In the film according to the present invention, the polymer is preferably selected from the group consisting of polyimide, polyetherimide, fluorinated polyimide, and polycarbonate.

The film according to the present invention preferably has a thickness of 50 $\mu$m to 500 $\mu$m.

The film according to the present invention may be used in a board for a millimeter-wave antenna.

[Effect of Invention]

The present invention makes it possible to obtain a low-dielectric porous polymer film having a low dielectric constant at high millimeter-wave frequencies and providing excellent circuit board processability, wherein this film can be used in a substrate of a millimeter-wave antenna to enhance the gain of the millimeter-wave antenna to increase a millimeter-wave communication range.

BRIEF DESCRIPTION OF DRAWINGS

FIG. 1 is a schematic diagram showing various examples of a laminate structure comprising: a film layer comprising a film according the present invention: and an electroconductive layer.

FIG. 2 is a schematic diagram showing various examples in which a conducting part is provided in the laminate structure comprising the film according the present invention.

FIG. 3 is an SEM photograph of a cut surface of a film obtained in Inventive Example 1.

FIG. 4 is an SEM photograph of a cut surface of a film obtained in Inventive Example 2.

FIG. 5 is an SEM photograph of a cut surface of a film obtained in Comparative Example 1.

DESCRIPTION OF EMBODIMENTS

A low-dielectric porous polymer film according to the present invention is made of a polymer material and formed with fine pores dispersed therein, wherein the film has a given porosity, and the pores have a given average pore diameter, and wherein a porous structure of the film is a closed-cell structure.

With a view to obtaining a high antenna gain, it is desirable for the film according to the present invention to have a lowered dielectric constant. From this viewpoint, the porosity of the film is set to 60% or more, preferably 70% or more. Further, the porosity of the film is preferably set to 95% or less. The porosity of the film can be obtained by calculation based on the specific gravity of a non-porous polymer film and the specific gravity of the porous polymer film, each measured by an electron specific gravity meter.

From a viewpoint that an excessive enlargement of the pores leads to significant deterioration in mechanical strength during bending of the porous polymer film, the film according to the present invention is formed such that the pores have an average pore diameter of 50 $\mu$m or less, preferably 30 $\mu$m or less, more preferably 10 $\mu$m or less. Further, in the film according to the present invention, a substantially smooth skin layer made of the same polymer material as that of the film may be formed as a surface layer of the porous polymer film. This skin layer is useful in forming antenna wires on the surface of the porous polymer film. In this case, however, if there are irregularities on a surface of the skin layer, irregularities will be undesirably formed in the wires formed thereon. For this reason, the skin layer needs to be smooth. Further, as the skin layer is increased in thickness, the dielectric constant of the entire film undesirably rises. Thus, the skin layer needs to be thinned. In the film according to the present invention, the average pore diameter of the pores is set to 10 $\mu$m or less. This makes it possible to easily realize formation of a thin and smooth skin layer as a surface layer of the porous polymer film.

Further, from viewpoints of further improving the mechanical strength during bending of the porous polymer film, and, in the case where a skin layer is formed as a surface layer of the porous polymer film, further improving the smoothness of the skin layer, the pores have a pore diameter distribution with a full width at half maximum which is preferably 15 $\mu$m or less, more preferably 10 $\mu$m or less. The average pore diameter of the pores and the full width at half maximum in the pore diameter distribution of the pores can be measured by image analysis of an SEM photograph of a cut surface (cut section) of the film.

The porous structure of the film according to the present invention is a closed-cell structure. As used in this specification, the term "closed-cell structure" may include not only a structure having only a plurality of closed pores (each of which is not communicated with adjacent ones of the remaining pores) but also a structure additionally having an interconnected pore (composed of some adjacent pores communicated with each other) to the extent that does not impair the advantageous effects of the present invention. For example, the closed-cell structure may be formed as a porous structure in which the closed pores account for 80% or more of the entire pores.

Whether the porous structure of the film according to the present invention is the closed-cell structure can be checked using a penetrant (liquid penetrant) to be used in, e.g., the Penetrant Test defined in JIS (JIS Z 2343-1, etc.). In this case, it is preferable to use a penetrant having a contact angle with respect to a polymer surface of 25° or less, and a viscosity of 2.4 mm$^2$/s (37.8°C). Specifically, the porous polymer film is cut approximately perpendicularly with respect to a surface thereof so as to form a porous cut surface exposed to the outside, and, after immersing this cut surface in a penetrant such as a red penetrant for 5 minutes, a liquid penetration length (a distance by which the penetrant penetrates into the porous polymer film from the cut surface) is measured. In the film according to the present invention, the liquid penetration length is preferably 500 $\mu$m or less, more preferably 300 $\mu$m or less.

For example, the porous polymer film according to the present invention can be obtained by forming a polymer composition having a microphase-separated structure through the following drying-induced phase separation method, and then using a supercritical extraction method. Specifically, a porosifying agent is added to a solution of a polyamide precursor using an organic solvent (NMP or the like) at a given mixing ratio, and the resulting solution is formed in a desired shape (e.g., a sheet, a film or the like), for example, by applying it onto a substrate such as a PET film, a copper foil or the like. Then, the solvent is removed from the resulting shaped body by drying, and the porosifying agent is insolubilized within the polyimide precursor to obtain a polymer composition having a microphase-separated structure in which non-continuous phases comprised of the porosifying agent are dispersed over a continuous phase of the polyimide precursor. Further, the porosifying agent is extracted using supercritical carbon dioxide or the like, and then the polyimide precursor is converted to polyimide (imidized). In the above process, the drying is performed at a relatively low temperature for a relatively short time period to intentionally allow part of the organic solvent such as NMP to remain, and, in this state, the porosifying agent is extracted using supercritical carbon dioxide or the like, whereby a film having a desired porosity and a desired average pore diameter can be obtained.

The porous polymer film according to the present invention may have a long strip shape, or may have a short rectangular shape. When the porous polymer film has a short rectangular shape, the length thereof may be appropriately set without particular restrictions. On the other hand, when the porous polymer film has a long strip shape, the length thereof is not particularly restricted, and the film may be in the form of a roll-like wound body

When the porous polymer film has a long strip shape, a long strip-shaped porous polymer film having a microphase-separated structure can be obtained through, e.g., the following continuous film formation process. Specifically, a polymerization solution of a polyamide precursor is applied onto an unrolled long substrate (a PET film, a copper foil or the like). Subsequently, the resulting laminate is subjected to drying and then wound up to obtain a wound body of a laminate comprising a polymer composition having a microphase-separated structure in which non-continuous phases comprised of a porosifying agent are dispersed over a continuous phase of the polyimide precursor. Subsequently, in the state of the wound body, the porosifying agent is extracted using supercritical carbon dioxide or the like, and then the polyimide precursor is converted to polyimide (imidized) to obtain a wound body of a laminate having a porous structured polyimide layer. Further, an adhesive layer-attached long strip-shaped substrate obtained by applying an adhesive layer to another substrate and drying the adhesive layer is prepared, and subjected to lamination with respect to the wound body of the laminate comprising the porous structured polyimide layer, to obtain a wound body of a film in which identical or different substrates are laminated, respectively, to opposite surfaces of the porous structured polyimide layer. In this process, as needed, heat or pressure may be applied to the wound body of the long strip-shaped film in which the two substrates are laminated, respectively, to the opposite surfaces of the porous structured polyimide layer, to promote curing or bonding. In this way, it is possible to obtain a wound body of a long strip-shaped porous polymer film in which two substrates are laminated, respectively, to opposite surfaces' of a porous structure.

The obtained long film in which the substrates are laminated, respectively, to the opposite surfaces of the porous structure may be subjected to, e.g., but not limited to, a segmentation process such as cutting or punching so as to be segmented into a plurality of short rectangular sheets, as needed basis.

As used in this specification, the term "long strip shape" means a shape which is elongated in one direction to form a strip (a shape whose length in a longitudinal direction is greater than length in a width direction). Preferably, in a production process, the long film is continuously fed from or conveyed in the form of a roll (wound body) or the like. More preferably, such a wound body is formed such that the long strip-shaped film is wound around a winding core or the like.

As the substrate onto which the polyamide precursor solution is applied, it is possible to use a metal material (e.g., copper, silver, gold, nickel, or an alloy or solder containing one or more of them), and a polymer material (e.g., polyether nitrile resin, polyether sulfone resin, polyethylene terephthalate resin, polyethylene naphthalate resin, or polyvinyl chloride resin). As the metal material, copper is preferable.

In a case where the metal material is used as a substrate, the substrate can be used as an electroconductive layer. In this case, by forming the substrate of the metal material into a given wiring pattern, the substrate can be used as a circuit. In the case where the substrate of the metal material is used as wiring pattern, the thickness of the metal material is preferably set in, but not limited to, the range of 8 to 35 $\mu$m.

On the other hand, in a case where the polymer material such as PET (polyethylene terephthalate) is used as a substrate, an isolated porous polymer film can be obtained by forming a porous polymer film on the substrate and then removing the substrate of the polymer material. Then, an electroconductive layer may be formed on a surface of the porous polymer film obtained in the above manner to form a wiring pattern. This electroconductive layer can be obtained, e.g., by forming the electroconductive layer on the porous polymer film through sputtering or by bonding the electroconductive layer to the surface of the porous polymer film.

The polyimide precursor usable for obtaining the film according to the present invention may be any intermediate capable of being converted to polyimide, and can be obtained by a heretofore-known or commonly-used method. For example, the polyimide precursor can be obtained by causing a reaction between an organic tetracarboxylic dianhydride and a diamino compound (diamine).

Examples of the organic tetracarboxylic dianhydride include pyromelletic dianhydride, 3,3',4,4'-biphenyltetracarboxylic dianhydride, 2,2-bis(2,3-dicarboxyphenyl)-1,1,1,3,3,3-hexafluoropropane dianhydride, 2,2-bis(3,4-dicarboxyphenyl)-1,1,1,3,3,3-hexafluoropropane dianhydride, 3,3'4,4'-benzophenonetetracarboxylic dianhydride, bis(3,4-dicarboxyphenyl)-ether dianhydride, and bis(3,4-dicarboxyphenyl)-sulfonic dianhydride. These organic tetracarboxylic dianhydrides may be used independently or in the form of a mixture of two or more of them.

Examples of the diamino compound include m-phenylenediamine, p-phenylenediamine, 3,4'-diaminodiphenyl ether, 4,4'-diaminodiphenyl ether, 4,4'-diaminodiphenyl sulfone, 3,3'-diaminodiphenyl sulfone, 2,2-bis(4-aminophenoxyphenyl)propane, 2,2-bis(4-aminophenoxyphenyl) hexafluoropropane, 1,3-bis(4-aminophenoxy)benzene, 1,4-bis(4-aminophenoxy)benzene, 2,4-diaminotoluene, 2,6-diaminotoluene, diaminodiphenylmethane, 4,4'-diamino-2,2-dimethylbiphenyl, and 2,2-bis(trifluoromethyl)-4,4'-diaminobiphenyl. These diamino compounds may be used independently or in the form of a mixture of two or more of them.

The polyimide precursor can be obtained by, but not limited to, causing a reaction between the organic tetracarboxylic dianhydride and the diamino compound (diamine), typically in an organic solvent at 0 to 90°C for 1 to 24 hours. In the reaction for obtaining the polyimide precursor, various conditions such as external conditions during mixing (before initiation of the reaction), in early to last stages of the reaction, etc., can be appropriately set, as needed basis. Examples of the organic solvent include polar solvents such as N-methyl-2-pyrrolidone, N,N-dimethylacetamide, N,N-dimethylformamide, and dimethylsulfoxide. Among them, from the viewpoint that a film having a relatively high porosity and a relatively small average pore diameter can be obtained by intentionally creating the state in which part of the organic solvent remains in the film, and, in this state, extracting the porosifying agent, it is preferable to use N-methyl-2-pyrrolidone whose remaining amount can be easily controlled through control of a drying condition, in a production process of the film, as described later,

The porosifying agent usable for obtaining the film according the present invention may be a component comprising the non-continuous phases in the microphase-separated structure (which are equivalent to pores in the porous polymer film) and capable of being dispersed over the polyimide precursor upon being mixed with the polyimide precursor, more specifically a compound capable of being separated with respect to the polyimide precursor, in the form of fine particle-shaped microphases, so as to form a sea-island structure. More preferably, the porosifying agent is a component capable of being removed from the polyimide precursor by an extractive removal operation using supercritical carbon dioxide or the like. Further, the porosifying agent for use in the present invention is a type capable of allowing the porous structure of the obtainable film to become a closed-cell structure.

More specifically, the porosifying agent may be polyoxyethylene dimethyl ether. By using polyoxyethylene dimethyl ether as the porosifying agent, it becomes possible to allow the porous structure of the obtainable film to become a closed-cell structure. One or more of other porosifying agents including, e.g.: polyalkylene glycols such as polyethylene glycol and polypropylene glycol; a substance in which one or each of two terminals of the polyalkylene glycols is blocked by methyl or (meth)acrylate; a compound in which one of two terminals of polyalkylene glycol such as phenoxypolyethylene glycol (meth)acrylate is blocked by an alkyl or aryl group, and the other terminal is blocked by (meth)acrylate; urethane prepolymer; polyhydric alcohol poly(meth)acrylates such as trimethylolpropane tri(meth)acrylate and dipentaerythritol hexa(meth)acrylate; and (meth)acrylate-based compounds such as $\varepsilon$-caprolactone (meth)acrylate, urethane (meth)acrylates, epoxy (meth)acrylates, and oligoester (meth)acrylates, may be used in combination with polyoxyethylene dimethyl ether, to the extent that the porous structure of the obtainable film becomes a closed-cell structure.

In the film according to the present invention, with a view to allowing the porous structure to become a closed-cell structure, it is possible to add, as a nucleation agent; an oxide, a complex oxide, a metal carboxylate, a metal sulfate or a metal hydroxide, such as, an insoluble silica or ceramic-based powder, talc, alumina, zeolite, calcium carbonate, magnesium carbonate, barium sulfate, zinc oxide, titanium oxide, aluminum hydroxide, magnesium hydroxide, mica, and montmorillonite; polymer particles; carbon particles; glass fibers; or carbon nanotubes, to NMP, as needed basis. These additives may be used independently or in combination of two or more of them. As the nucleation agent, it is preferable to use a polytetrafluoroethylene (PTFE) powder. The particle size of the nucleation agent is preferably 10 μm or less, more preferably 5 μm or less. The nucleation agent may be added in an amount of 0.5 to 20 weight parts with respect to 100 weight parts of the polyimide precursor.

In a process of obtaining the film according to the present invention, first of all, the porosifying agent is added to a solution of the polyimide precursor using the organic solvent, at a given mixing ratio, and, after forming the resulting solution into a sheet, a film or the like, the solvent is removed from the sheet or the like by drying, as mentioned above. With regard to the drying for removing the solvent, drying conditions are not particularly limited, but may be appropriately set, depending on its intended purpose, e.g., an intended solvent removal rate. In the step of forming the solution of the polyimide precursor into a sheet, a film or the like, the solution may be applied onto a substrate and then dried, whereby the solution can be formed into a given shape. After forming the solution into a given shape, the substrate can be peeled off to obtain an isolated porous polymer film having a sheet shape or the like.

The temperature of the drying for removing the solvent may be set in the range of 60 to 180°C, preferably in the range of 60 to 120°C, although it varies depending on a type of solvent to be used. Further, the time period of the drying is preferably set in the range of 5 to 60 minutes, more preferably in the range of about 5 to 30 minutes.

A film having a high porosity and a small average pore diameter which could not be obtained by conventional techniques can be obtained by performing the drying at a lower temperature for a shorter time period than those in the conventional techniques to thereby intentionally create the state in which part of the organic solvent such as NMP remains in the film, and, in this state, extracting the porosifying agent using supercritical carbon dioxide, although not limited to such a specific theory.

A remaining amount of the solvent is preferably set in the range of 15 to 250 weight parts, more preferably in the range of 20 to 150 weight parts, with respect to the amount of the polyimide precursor.

From a viewpoint of setting the average pore diameter to a sufficiently small value, an addition amount of the porosifying agent is preferably set to 200 weight parts or less with respect to 100 weight parts of the polyimide precursor. Further, from a viewpoint of setting the dielectric constant of the film to a sufficiently small value, the porosifying agent is preferably added in an amount of 10 weight parts or more with respect to 100 weight parts of the polyimide precursor.

From a viewpoint of allowing the porous structure to become an closed-cell structure, it is preferable to use, as the porosifying agent, a type having excellent compatibility with a polymer.

Subsequently, a porous structure is formed by removing the porosifying agent from a polymer composition having a microphase-separated structure composed of the polyimide precursor and the porosifying agent. A method for removing the porosifying agent is not particularly limited. However, a removal method based on an extraction operation is preferable, although the removal may be performed based on any other method such as vaporization or decomposition. The removal based on the extraction operation may involve decomposition or transformation of the porosifying agent or may be performed after decomposition or transformation.

The solvent to be used for the extractive removal of the porosifying agent is not particularly limited as long as it is capable of solving the porosifying agent. However, carbon dioxide, particularly supercritical carbon dioxide, is preferable from a viewpoint of its removal performance and harmlessness. In a method for removing the porosifying agent from the polyimide composition by using supercritical carbon dioxide, a temperature for performing the method is preferably set in a temperature range where imidization of the polyimide precursor is not extremely progressed in the course of the removal, although it may be equal to or greater than the critical point of supercritical carbon dioxide. Further, as the temperature is set to a higher value, solubility of the porosifying agent with respect to the supercritical carbon dioxide becomes lower. Therefore, a temperature (extraction temperature) during removal of the porosifying agent using supercritical carbon dioxide is preferably set in the range of 32 to 230°C, more preferably in the range of 40 to 200°C.

The pressure of the supercritical carbon dioxide is equal to or greater than the critical point of supercritical carbon dioxide, and is preferably set in the range of 7.3 to 100 MPa, more preferably in the range of 10 to 50 MPa.

The supercritical carbon dioxide may be pressurized and then continuously supplied to a pressure-resistant container containing the polymer composition having the microphase-separated structure by using a metering pump, or may be prepared as supercritical carbon dioxide pre-pressurized at a given pressure, and injected into the pressure-resistant container. The time period of the extraction is set in the range of about 1 to 10 hours, although it varies depending on the extraction temperature, the extraction pressure, and the amount of the porosifying agent added to the polyimide precursor. In the removal of the porosifying agent by using supercritical carbon dioxide, external conditions such as temperature and pressure may be appropriately set, as needed basis. Here, in a case where the porous polymer film is in the form of a wound body of a long strip thereof, a wound body of the polymer composition having the microphase-separated structure may be placed (set) in a pressure-tight container.

The porosified polyimide precursor from which the porosifying agent has been removed in the above manner is subsequently converted to a porous polyimide through, e.g., a dehydration ring-closure reaction. The dehydration ring-closure reaction of the polyimide precursor is performed under heating at about 300 to 400°C, or under the action of a cyclodehydrating agent such as a mixture of acetic anhydride and pyridine. In the case where the porous polymer film is in the form of a wound body of a long strip thereof, a wound body of a long strip of the polyimide precursor porosified by removal of the porosifying agent is placed (set) in a given device and subjected to a dehydration ring-closure reaction, whereby the porosified polyimide precursor can be converted to porous polyimide. In the conversion to porous polyimide, a heating device may be used as the above given device. In this case, external conditions such as pressure may be appropriately set.

The film according to the present invention which can be produced by the above method has a dielectric constant as measured at 10 GHz which is preferably 2.0 or less, more preferably 1.5 or less, from a viewpoint of lowering of dielectric constant. The dielectric constant of the film can be measured by an open resonator method or the like.

Although the above production method has been described in detail based on an example in which the polymer is polyimide, the polymer is preferably selected from the group consisting of polyimide, polyetherimide, fluorinated polyimide, and polycarbonate, from a viewpoint that a drying-induced phase separation method and a supercritical extraction method can be applied to the film according to the present invention.

The film according to the present invention preferably has a thickness of 50 $\mu$m to 500 $\mu$m, from a viewpoint that the film is formed through the application and drying process.

The film according to the present invention is suitably usable as, but not limited to: wireless communication parts, such as a film for use in a board, particularly, for a millimeter wave antenna and a millimeter wave radar; a flexible circuit board, particularly, a base substrate or a sealing layer for high-frequency transmission; and a general-purpose porous polymer film such as a separator film of a fuel cell.

It is conceivable that the film according to the present invention is used in the form of a laminate structure in which an electroconductive layer such as a metal layer is provided on at least one of opposite surfaces of the film according to the present invention. By doing so, it becomes possible to use the laminate as a circuit board by subjecting a metal foil to wiring pattern processing, or as an antenna member having a conducting structure. For example, in a case where the film according to the present invention is used in a board for a millimeter antenna, after providing an electroconductive layer on each of upper and lower surfaces of the film to form a laminate structure, a conducting part may be formed in the laminate structure to electrically connect the electroconductive layers on the upper and lower surfaces of the film. In the film according to the present invention, the porous structure thereof is a closed-cell structure. Thus, even when such a conducting part is formed, it is possible to prevent the occurrence of a problem such as insulation failure.

In the present invention, it is preferable to produce a metal foil-attached porous polymer film in which a substrate such as a metal foil is laminated to the porous polymer film. The metal foil can be formed into a circuit through the wiring pattern processing, as mentioned above.

Examples of the wiring pattern processing method (forming method) include a method which comprises patterning a metal layer used as a substrate and peeling off an unnecessary part of the metal layer; and a method which comprises subjecting the metal layer to etching such as dry etching or wet etching. In the above methods, it is preferable to use etching, particularly wet etching. As the metal foil, it is preferable to use a copper foil.

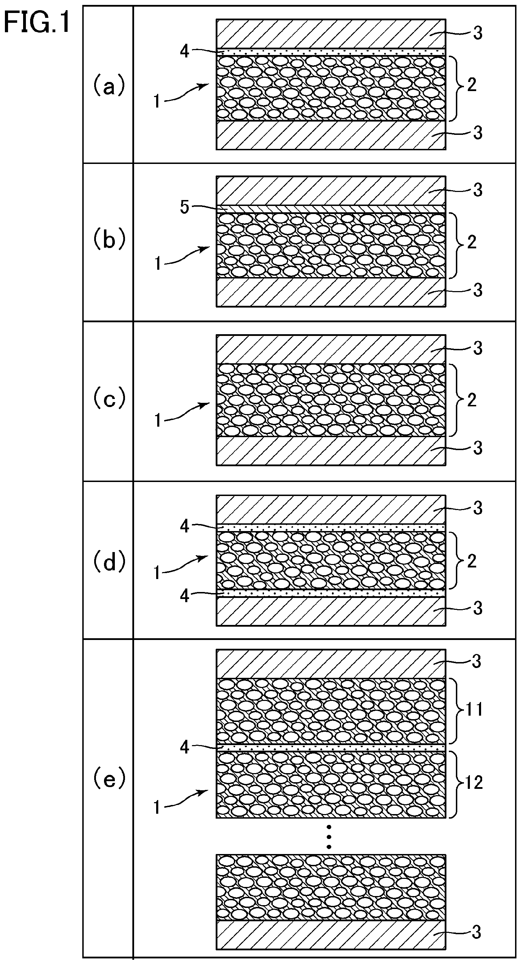

With reference to FIGS. 1(a) to 1(e), examples of a production method for a laminate structure comprising: a film according the present invention, and an electroconductive layer provided on at least one of opposite surfaces of the film.

Referring to FIG. 1(a), a laminate structure 1 comprises a porous polymer film 2, and two copper foils 3, 3 (electroconductive layers) formed, respectively, on opposite surfaces of the porous polymer film 2. This laminate structure 1 can be formed by: forming the porous polymer film 2 on an upper surface of a lower one 3 of the copper foils; then forming an adhesive layer 4 on a copper foil unformed surface of the porous polymer film 2; and laminating an upper one 3 of the copper foils to the adhesive layer 4.

Referring to FIG. 1(b), a laminate structure 1 can be formed by: forming the porous polymer film 2 on the upper surface of the lower copper foil 3; then subjecting the copper foil unformed surface of the porous polymer film 2 to sputtering to form thereon an adhesion layer 5 comprising Cr or NiCr; and laminating the upper copper foil 3 to the adhesion layer 5.

Referring to FIG. 1(c), a laminate structure 1 can be formed by: forming the porous polymer film 2 on the upper surface of the lower copper foil 3; then subjecting the copper foil unformed surface of the porous polymer film 2 to surface treatment; and laminating the upper copper foil 3 directly to the treated surface. Examples of this surface treatment include, but not limited to, discharge treatment such as plasma treatment or corona treatment.

Referring to FIG. 1(d), a laminate structure 1 can be formed by: forming a porous polymer film on a substrate of a polymer material; then removing the substrate of the polymer material to form an isolated porous polymer film 2; then forming two adhesive layers 4, 4, respectively, on upper and lower surfaces of the porous polymer film 2; and laminating upper and lower copper laminates 3, 3, respectively, to the adhesive layers 4, 4.

The laminate structures shown in FIGS. 1(a) to 1(c) have been described based on an example where the porous polymer film 2 is formed on the upper surface of the lower copper foil 3. Alternatively, each of the laminate structures may be formed by: forming an isolated porous polymer film 2; and then laminating the lower copper foil 3 to a lower surface of the porous polymer film 2, using a technique identical to or different from that described as the technique of laminating the upper copper foil 3.

Further, a copper foil 3 preliminarily formed with an adhesive layer 4 may be laminated to a porous polymer film 2 formed with no adhesive layer, whereby it is possible to obtain a porous polymer film having the copper foil 3 formed on each or one of opposite surfaces of the porous polymer film.

In the case of using the adhesive layer 4, the thickness of the adhesive layer 4 is preferably set in the range of about 1 to 20 $\mu$m. Further, as the adhesive layer 4, it is preferable to use a low-dielectric adhesive layer having a dielectric constant of about 1.1 to 2.5.

In the case where the porous polymer film is in the form of a wound body of a long strip thereof, a long strip-shaped member having a porous structure may be laminated to an adhesive layer-attached long strip-shaped substrate, whereby it is possible to obtain a laminated structure in which the substrate is laminated to each of one of opposite surfaces of the long strip-shaped member having the porous structure. Various external conditions during formation of the adhesive layer may be appropriately set.

In the case where a sputtered layer is used as the adhesion layer 5, the thickness of the sputtered layer is preferably set in the range of about 0.02 to 1.00 $\mu$m. As a material to be used for the sputter layer, it is preferably to use a metal belonging to Group 11 in the periodic table and the 4th and 5th periods in the IUPAC periodic table. Alternatively, the adhesion layer 5 may be formed by applying a material capable of easily supporting a non-electrolytic plating catalyst, to a surface of the porous polymer film 2, and performing non-electrolytic plating. For example, the non-electrolytic plating may be performed using a polypyrrole nano-dispersion (manufactured by ACHILLES Corporation) to allow a Pd catalyst to be supported.

With a view to enhancing an adhesion force between the porous polymer film 2 and the adhesive layer 4 or the adhesion layer 5, or between the porous polymer film 2 and a wiring layer such as the copper foil 3, a layer having a functionality may be provided on one or each of opposite surfaces of the adhesive layer 4 or the adhesion layer 5.

Further, referring to FIG. 1(e), it is possible to obtain a laminate structure 1 which comprises a porous polymer film laminate having a desired thickness, wherein the porous polymer film laminate is prepared by laminating a plurality of porous polymer films 11, 12, ----, through adhesive layers.

After providing two electroconductive layers, respectively, on the upper and lower surfaces of the film to form a laminate structure, in the above manner, a conducting part may be formed in the laminate structure to electrically connect the electroconductive layers on the upper and lower surfaces of the film, whereby the resulting laminate structure can be used in a board for a millimeter-wave antenna. Such a conducting part may be formed in at least one or more areas of the porous polymer film.

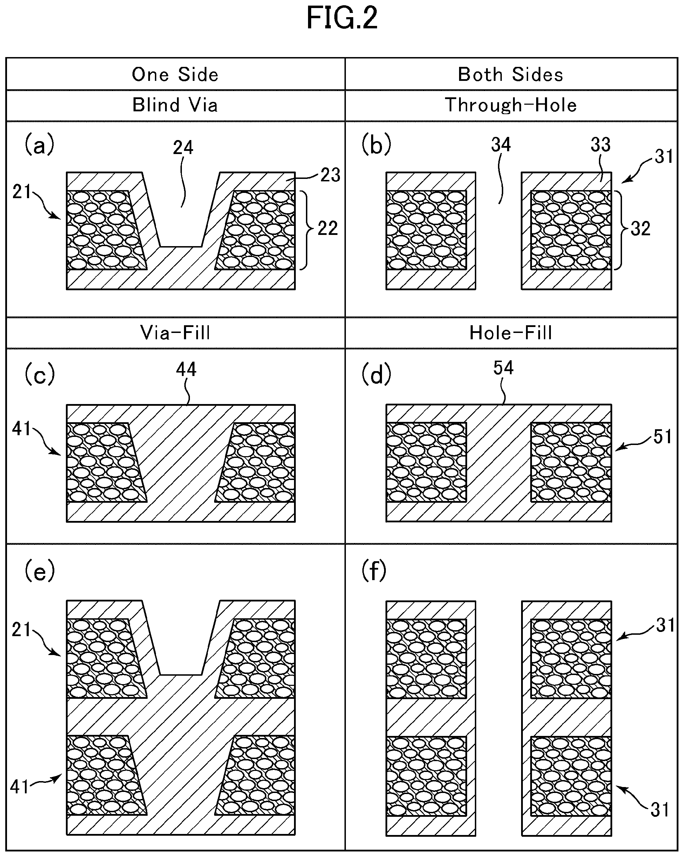

Examples of the conducting part which can be provided in the laminate structure comprising the film according to the present invention include: a structure having a concave portion in a film thickness direction of the laminate structure, such as a blind via as shown in FIG. 2(a), or a through-hole as shown in FIG. 2(b); a structure in which a concave portion provided in the film thickness direction is filled with an electroconductive member, such as a via-fill as shown in FIG. 2(c), or a hole-fill as shown in FIG. 2(d); and a structure in which a plurality of conducting parts are laminated, such as a combination of a blind via and a via-fill as shown in FIG. 2(e), or a combination of two through-holes as shown in FIG. 2(f).

When the conducting part is provided in the laminate structure comprising the film according to the present invention, the following techniques can be employed.

First of all, referring to FIG. 2(a), a laminate structure 21 provided with a blind via 24 can be produced by: forming a porous polymer film 22 on a copper foil; then forming a via from the side of a copper foil unformed surface of the porous polymer film 22; and subjecting the copper foil unformed surface of the porous polymer film 22 including the via to copper plating.

Reference to FIG. 2(b), a laminate structure 31 provided with a through-hole 34 can be produced by: forming two copper foils 33, 33, respectively, on opposite surfaces of a porous polymer film 32; then forming a via to penetrate through the porous polymer film 32 and the copper foils 33, 33; and subjecting an inner peripheral surface of a portion penetrated by the via to copper plating.

Reference to FIG. 2(c), a laminate structure 41 provided with a via-fill 44 can be produced by: forming a via in the same manner as that in the structure shown in FIG. 2(a); and then performing copper plating to fill a concave space of the via.

Similarly, reference to FIG. 2(d), a laminate structure 51 provided with a hole-fill 54 can be produced by: forming a via in the same manner as that in the structure shown in FIG. 2(b); and then performing copper plating to fill a hole of the via penetrating through the porous polymer film.

Referring to FIG. 2(e), a stacked laminate structure provided with a conducting part can be obtained by stacking the laminate structure 21 provided with the blind via as shown in FIG. 2(a) on the laminate structure 41 provided with the via-fill as shown in FIG. 2(c).

Similarly, referring to FIG. 2(f), a stacked laminate structure provided with a conducting part can be obtained by: forming two copper foils, respectively, on the opposite surfaces of the porous polymer film as in the structure shown in FIG. 2(b); stacking the obtained laminate structure plurally to form a stacked laminate structure; then forming a via to penetrate through the stacked laminate structure; and subjecting an inner peripheral surface of a portion penetrated by the via to copper plating.

In the porous polymer film or the porous polymer film laminate, the copper film may be formed into a circuit through wiring pattern processing before or after forming the laminate structure.

Further, examples of a technique of forming a via include laser processing and drilling. Examples of a laser usable for the laser processing include a YAG laser and a carbon dioxide laser. The wavelength of a laser source to be used is not particularly limited.

EXAMPLES

Although the present invention will be specifically described below based on examples, it should be understood that the present invention is not limited to these examples.

(Evaluation of Porosity)

The specific gravity was measured using an electron specific gravity meter (MD-3005 manufactured by Alfa Mirage). Further, the porosity was calculated using the following formula.

$$\text{Porosity (\%)} = (1 - \text{the specific gravity of a porous polyimide body}/ \text{the specific gravity of a non-porous polyimide body}) \times 100$$

(Evaluation of Average Pore Diameter and Pore Diameter Distribution)

The average pore diameter and the pore diameter distribution were evaluated by observing a porous configuration using an electron scanning microscope (JSM-6510LV manufactured by LEOL Ltd.). A sample was cut by a razor, and a resulting cut surface was exposed to the outside. Further, the cut surface was subjected to platinum vapor deposition, and then observed. The average pore diameter and the pore diameter distribution (full-width at half-maximum) were calculated by SEM image analysis. In the image analysis, an SEM image was subjected to binarization to identify pores, and then pore diameters were calculated to form a histogram. As software for the analysis, ImageJ was used. A maximum one of the pore diameters best representing an actual structure was used as a value of the pore diameter in the evaluation of pore diameter.

(Thickness of Skin Layer)

In the film according to the present invention, a substantially smooth layer made of a polymer material of the film may be formed on a surface of the porous polymer film. This skin layer is considered to be useful in forming an antenna wiring on the surface of the porous polymer film. On the other hand, as the skin layer becomes thicker, the dielectric constant of the entire film will be undesirably increased. Thus, the skin layer is considered to be preferably thinned as much as possible.

The thickness of the skin layer was evaluated by observing a porous configuration using an electron scanning microscope (JSM-6510LV manufactured by LEOL Ltd.). A sample was cut by a razor, and a resulting cut surface was exposed to the outside. Further, the cut surface was subjected to platinum vapor deposition, and then observed. The thickness of the skin layer was calculated by SEM image analysis.

(Evaluation of Electric Properties)

The dielectric constant (relative permittivity) and the dielectric loss tangent at 10 GHz were measured using a PNA network analyzer (Agilent Technologies Inc.) and a split post dielectric resonator (SPDR).

(Evaluation of Liquid Penetration)

A porous polyimide body was cut by a razor, and a resulting cut surface was exposed to the outside. The cut surface was immersed in a red penetrant (NRC-ALII manufactured by Taiyo Bussan Co. Ltd.) for 5 minutes, and part of penetrant adhering to the cut surface was cleaned off. The cut porous polyimide body was further cut perpendicularly to the exposed cut surface to evaluate the liquid penetration length by an optical microscope.

(Evaluation of Collapse)

A porous polyimide body was cut into a size of 50 mm × 50 mm, and a resulting sample was pressed by hot pressing at 180°C and 3 MPa for 60 munities. Respective thicknesses of the sample before and after the pressing were measured, and, based on the measured values, a reduction in thickness of the sample was calculated after the pressing, as change rate.

(Migration Test)

A plurality of through-holes each having a bore diameter of 0.3 mm were made in a porous polyimide body at a pitch of 1.52 mm, and a plus electrode and a minus electrode were formed in each of the through-holes. Then, a voltage of 60 V was applied between the plus and minus electrodes at 85°C and 85%RH to measure an insulation resistance value.

Reference Example

(Synthesis of Polyimide Precursor [BPDA/PDA, DPE])

43.2 g of p-phenylenediamine (PDA) and 20g of diaminodiphenyl ether (DPE) were put into a 1000-ml flask equipped with a stirrer and a thermometer, and 768.8 g of N-methyl-2-pyrolidone (NMP) was added thereto and dissolved therein by steering. Subsequently, 147g of biphenyltetracarboxylic acid dianhydride (BPDA) was gradually added to the above solution, and the resulting solution was steered at 40°C for 2 hours to promote reaction. Further, the mixture was steered at 75°C for 12 hours to perform aging. As a result, a polyimide precursor solution having a solid content concentration of 20 wt% was obtained. This polyimide precursor has the following composition in terms of substance amount ratio: PDA: DPE : BPDA = 0.8 mol: 0.2 mol: 1 mol.

Inventive Example 1

With respect to 100 weight parts of the polyimide precursor solution obtained in Reference Example, 200 weight parts of polyoxyethylene dimethyl ether having a weight-average molecular weight of 400 (grade: MM400, manufactured by NOF Corporation) and 150 weight parts of NMP were added to the polyimide precursor solution. Then, the resulting solution was steered to obtain a transparent homogeneous solution. Subsequently, 4.2 weight parts of 2-methylimidazole serving as an imidizing catalyst was added to the above obtained solution to form a mixed solution. This mixed solution was applied onto a PET film or a copper foil by a die process, and dried by hot air at 120°C for 30 minutes to produce a 100 $\mu$m-thick polyimide precursor film having a phase-separated structure.

This film was immersed in carbon dioxide circulated at 40°C while being pressurized to 30 MPa, for 8 hours, to promote extractive removal of the polyoxyethylene dimethyl ether, phase separation of a remaining part of the NMP, and pore formation. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

Inventive Example 2

With respect to 100 weight parts of the polyimide precursor solution obtained in Reference Example, 200 weight parts of polyoxyethylene dimethyl ether having a weight-average molecular weight of 400 (grade: MM400, manufactured by NOF Corporation), 10 weight parts of a PTFE powder having a particle diameter of about 2 $\mu$m, and 150 weight parts of NMP were added to the polyimide precursor solution. Then, the resulting solution was steered to obtain a transparent homogeneous solution. Subsequently, 4.2 weight parts of 2-methylimidazole serving as an imidizing catalyst was added to the above obtained solution to form a mixed solution. This mixed solution was applied onto a PET film or a copper foil by a die process, and dried by hot air at 120°C for 30 minutes to produce a 100 $\mu$m-thick polyimide precursor film having a phase-separated structure.

This film was immersed in carbon dioxide circulated at 40°C while being pressurized to 30 MPa, for 8 hours, to promote extractive removal of the polyoxyethylene dimethyl ether, phase separation of a remaining part of the NMP, and pore formation. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

Comparative Example

With respect to 100 weight parts of the polyimide precursor solution obtained in Reference Example, 200 weight parts of polypropylene glycol having a weight-average molecular weight of 400 (grade: D400, manufactured by NOF Corporation) and 400 weight parts of NMP were added to the polyimide precursor solution. Then, the resulting solution was steered to obtain a transparent homogeneous solution. Subsequently, 4.2 weight parts of 2-methylimidazole serving as an imidizing catalyst was added to the above obtained solution to form a mixed solution. This mixed solution was applied onto a PET film or a copper foil by a die process, and dried by hot air at 120°C for 30 minutes to produce a 100 $\mu$m-thick polyimide precursor film having a phase-separated structure.

This film was immersed in carbon dioxide circulated at 40°C while being pressurized to 30 MPa, for 8 hours, to promote extractive removal of the polypropylene glycol, phase separation of a remaining part of the NMP, and pore formation. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

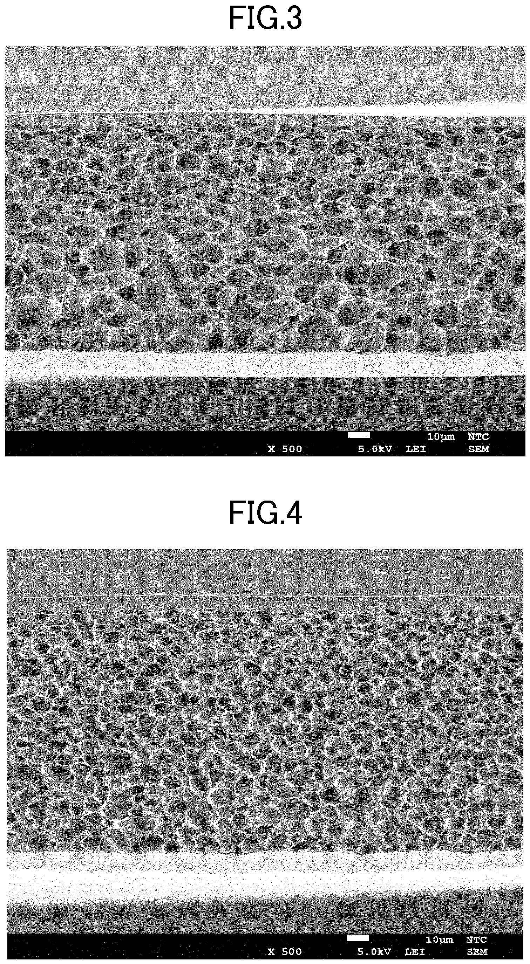

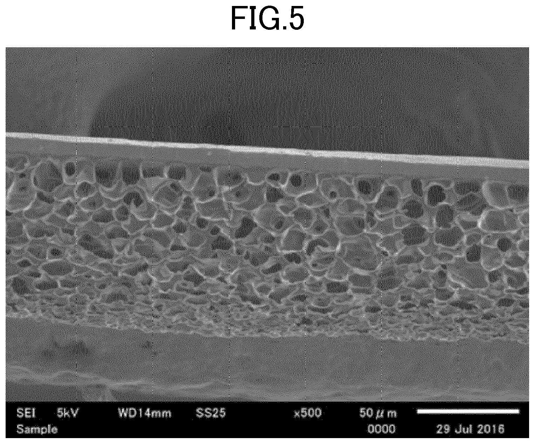

Results acquired by observing respective cut surfaces of the films obtained in Inventive Examples 1 and 2 and Comparative Example are shown in FIG. 3 (Inventive Example 1), FIG. 4 (Inventive Example 2) and FIG. 5 (Comparative Example).

Next, results of measurements performed for the films obtained in Inventive Examples 1 and 2 and Comparative Example are shown in Table 1.

[TABLE 1]

| Dielectric Constant 10GHz | Dielectric Loss Tangent 10GHz | Liquid Penetration | Evaluation of Collapse | Migration |
|---|---|---|---|---|
| 1.49 | 0.004 | 200 $\mu$m | 6% | 5.88E + 10 ($\Omega$) |
| 1.48 | 0.004 | 20 $\mu$m | 4% | 6.93E + 10 ($\Omega$) |
| 1.37 | 0.003 | 1 mm | 23% | 1.83E + 9 ($\Omega$) |

As a result of the SEM observation, the films obtained in Inventive Examples 1 and 2 had, respectively, skin layers with good thicknesses, specifically 4.8 $\mu$m and 6.0 $\mu$m.

Further, a laminate structure comprising each of the obtained films was produced, and a through-hole was formed therein. Then, the resulting laminate structure was subjected to evaluation of migration. As a result, it was verified that a good conducting part was formed without penetration of a copper plating solution from a cutting surface of the through-hole.

Subsequently, a circuit-equipped laminate structure was formed by: laminating two copper foils, respectively, to opposite surfaces of each of the porous polyimide films (porous polyimide members) obtained in Inventive Examples 1 and 2 through an adhesive layer; subjecting the copper foil on each of the opposite surfaces to wiring pattern processing to form a circuit therein; then laminating a copper foil-attached porous polyimide member to a surface of one of the circuits such that a cupper foil of the copper foil-attached porous polyimide member is located at an outermost position; and subjecting the outermost cupper foil to the wiring pattern processing.

Then, this circuit-equipped laminate structure was subjected to conducting part-forming processing to form a conducting part thereinside.

The circuit-equipped laminate structure having the conducting part thereinside was subjected to the evaluation of liquid penetration and the migration test in the same manner as those in Inventive Examples 1 and 2. As a result, good properties could be ascertained as with Inventive Examples 1 and 2.

Inventive Example 3

With respect to 100 weight parts of the polyimide precursor solution obtained in Reference Example, 200 weight parts of polypropylene glycol having a weight-average molecular weight of 400 (grade: D400, manufactured by NOF Corporation) and 400 weight parts of dimethylacetamide were added to the polyimide precursor solution. Then, the resulting solution was steered to obtain a transparent homogeneous solution. Subsequently, 4.2 weight parts of 2-methylimidazole serving as an imidizing catalyst and 5.4 weight parts of benzoic anhydride serving as a chemical imidizing agent were added to the above obtained solution to form a mixed solution. This mixed solution was applied onto a PET film or a copper foil by a die process, and dried by hot air at 85°C for 15 minutes to produce a 100 $\mu$m-thick polyimide precursor film having a phase-separated structure.

This film was immersed in carbon dioxide circulated at 40°C while being pressurized to 30 MPa, for 8 hours, to promote extractive removal of the polypropylene glycol, phase separation of a remaining part of the NMP, and pore formation. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

Inventive Example 4

With respect to 100 weight parts of the polyimide precursor solution obtained in Reference Example, 200 weight parts of polypropylene glycol having a weight-average molecular weight of 400 (grade: D400, manufactured by NOF Corporation) and 400 weight parts of dimethylacetamide were added to the polyimide precursor solution. Then, the resulting solution was steered to obtain a transparent homogeneous solution. Subsequently, 4.2 weight parts of 2-methylimidazole serving as an imidizing catalyst and 1.1 weight parts of benzoic anhydride serving as a chemical imidizing agent were added to the above obtained solution to form a mixed solution. This mixed solution was applied onto a PET film or a copper foil by a die process, and dried by hot air at 85°C for 15 minutes to produce a 100 $\mu$m-thick polyimide precursor film having a phase-separated structure.

This film was immersed in carbon dioxide circulated at 40°C while being pressurized to 30 MPa, for 8 hours, to promote extractive removal of the polypropylene glycol, phase separation of a remaining part of the NMP, and pore formation. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

Inventive Example 5

With respect to 100 weight parts of the polyimide precursor solution obtained in Reference Example, 200 weight parts of polypropylene glycol having a weight-average molecular weight of 400 (grade: D400, manufactured by NOF Corporation) and 400 weight parts of dimethylacetamide were added to the polyimide precursor solution. Then, the resulting solution was steered to obtain a transparent homogeneous solution. This mixed solution was applied onto a PET film or a copper foil by a die process, and dried by hot air at 80°C for 15 minutes to produce a 100 $\mu$m-thick polyimide precursor film having a phase-separated structure.

This film was immersed in carbon dioxide circulated at 40°C while being pressurized to 30 MPa, for 8 hours, to promote extractive removal of the polypropylene glycol. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

Results of measurements performed for the films obtained in Inventive Examples 3, 4 and 5 are shown in Table 2.

[TABLE 2]

|  | Poros ity (%) | Average Pore Diameter ($\mu$m) | Full Width at Half Maximum ($\mu$m) | Dielectric Constant 10GHz | Dielectric Loss Tangent 10GHz |
|---|---|---|---|---|---|
| Inventive Example 3 | 91 | 4.4 | 4 | 1.22 | 0.0017 |
| Inventive Example 4 | 84 | 7.5 | 6 | 1.40 | 0.0024 |
| Inventive Example 5 | 63 | 9.6 | 8 | 1.93 | 0.0063 |

As a result of the SEM observation, the films obtained in Inventive Examples 3, 4 and 5 had, respectively, skin layers with good thicknesses, specifically 2.2 $\mu$m, 3.6 $\mu$m, and 3.7 $\mu$m.

Further, the films obtained in Inventive Examples 3, 4 and 5 were subjected to the evaluation of liquid penetration in the same manner as that in Inventive Examples 1 and 2. As a result, good properties could be ascertained as with Inventive Examples 1 and 2.

Further, a laminate structure comprising each of the films obtained in Inventive Examples 3, 4 and 5 was produced, and a through-hole was formed therein. Then, the resulting laminate structure was subjected to evaluation of migration. As a result, it was verified that a good conducting part was formed without penetration of a copper plating solution from a cutting surface of the through-hole.

As is evident from the above results, the film according to the present invention, wherein the porous structure of the film is a closed-cell structure which can be ascertained by the fact that the liquid penetration length is sufficiently small, is excellent in terms of electrical properties, and is also excellent in terms of circuit board processability because it has excellent pressing resistance and exhibits a high insulation resistance value even after processing.

**Claims**

1. A porous low-dielectric polymer film which is made of a polymer material and formed with fine pores dispersed therein, wherein the film has a porosity of 60% or more, and the pores have an average pore diameter of 50 $\mu$m or less, and wherein a porous structure of the film is a closed-cell structure.

2. The film as recited in claim 1, wherein the porosity is 70% or more.

3. The film as recited in claim 1 or 2, wherein the average pore diameter of the pores is 30 $\mu$m or less.

4. The film as recited in claim 3, wherein the average pore diameter of the pores is 10 $\mu$m or less.

5. The film as recited in any one of claims 1 to 4, wherein the pores have a pore diameter distribution with a full width at half maximum of 15 $\mu$m or less.

6. The film as recited in claim 5, wherein the full width at half maximum in the pore diameter distribution of the pores is 10 $\mu$m or less.

7. The film as recited in any one of claims 1 to 6, which has a porous structure in which closed pores account for 80% or more of the entire pores.

8. The film as recited in claim 7, which has a porous structure having only closed pores.

9. The film as recited in any one of claims 1 to 8, which has a porous structure whose liquid penetration length is 500 $\mu$m or less as measured after immersing a cut surface of the film in a penetrant for 5 minutes.

10. The film as recited in claim 9, wherein the liquid penetration length is 300 $\mu$m or less.

11. The film as recited in any one of claims 1 to 10, which has a dielectric constant as measured at 10 GHz of 2.0 or less.

12. The film as recited in claim 11, wherein the dielectric constant as measured at 10 GHz is 1.5 or less.

13. The film as recited in any one of claims 1 to 12, wherein the polymer or a precursor of the polymer is soluble in an organic solvent.

14. The film as recited in claim 13, wherein the organic solvent is N-methylpyrrolidone.

15. The film as recited in any one of claims 1 to 14, wherein the polymer is selected from the group consisting of polyimide, polyetherimide, fluorinated polyimide, and polycarbonate.

16. The film as recited in any one of claims 1 to 15, which has a thickness of 50 $\mu$m to 500 $\mu$m.

17. The film as recited in any one of claims 1 to 16, which is used in a board for a millimeter-wave antenna.

18. A laminate structure comprising: the film as recited in any one of claims 1 to 17; and an electroconductive layer provided on at least one of opposite surfaces of the film.

19. The laminate structure as recited in claim 18, wherein the electroconductive layer is provided on the at least one surface of the film through an adhesive layer.

20. The laminate structure as recited in claim 18, wherein the laminate structure comprises a film laminate obtained by laminating the film plurally through or without through an adhesive layer.

21. The laminate structure as recited in any one of claims 18 to 20, wherein the electroconductive layer is provided on each of the opposite surfaces of the film of the film laminate, wherein the laminate structure further comprises a conducting part for electrically connecting the electroconductive layers on the opposite surfaces of the film layer.

FIG.1

# FIG.2

| One Side | Both Sides |
|---|---|
| Blind Via | Through-Hole |
| (a) | (b) |
| Via-Fill | Hole-Fill |
| (c) | (d) |
| (e) | (f) |

# FIG.3

# FIG.4

# FIG.5

## INTERNATIONAL SEARCH REPORT

| | International application No. |
|---|---|
| | PCT/JP2018/014710 |

A.  CLASSIFICATION OF SUBJECT MATTER
Int.Cl.  C08J9/28(2006.01)i,  H05K1/03(2006.01)i

According to International Patent Classification (IPC) or to both national classification and IPC

B.  FIELDS SEARCHED

Minimum documentation searched (classification system followed by classification symbols)
Int.Cl.  C08J9/28, H05K1/03

Documentation searched other than minimum documentation to the extent that such documents are included in the fields searched
Published examined utility model applications of Japan        1922-1996
Published unexamined utility model applications of Japan      1971-2018
Registered utility model specifications of Japan              1996-2018
Published registered utility model applications of Japan      1994-2018

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y | JP 2014-231533 A (NITTO DENKO CORP.) 11 December 2014, claims 1-6, paragraphs [0027], [0063]-[0066], [0071], [0080], [0081] & WO 2012/105678 A1 & CN 103347943 A | 1-20<br>21 |
| Y | JP 9-98016 A (MITSUBISHI ELECTRIC CORP.) 08 April 1997, claims 1, 5 (Family: none) | 21 |
| A | JP 2008-222836 A (FURUKAWA ELECTRIC CO., LTD.) 25 September 2008, claims 1-5, paragraphs [0005], [0018]-[0021] (Family: none) | 1-21 |
| A | JP 2002-146085 A (NITTO DENKO CORP.) 22 May 2002, claims 1-4, paragraphs [0008], [0037] & US 2002/0058720 A1, claims 1-4, paragraphs [0009], [0055] & EP 1205512 A1 & KR 10-2002-0037286 A & TW 285654 B | 1-21 |

☒    Further documents are listed in the continuation of Box C.　　☐    See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 29 June 2018 (29.06.2018) | 10 July 2018 (10.07.2018) |

| Name and mailing address of the ISA/<br>Japan Patent Office<br>3-4-3, Kasumigaseki, Chiyoda-ku,<br>Tokyo 100-8915, Japan | Authorized officer |
|---|---|
| | Telephone No. |

Form PCT/ISA/210 (second sheet) (January 2015)

**INTERNATIONAL SEARCH REPORT**

International application No.

PCT/JP2018/014710

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2012-29163 A (FURUKAWA ELECTRIC CO., LTD.) 09 February 2012, claims 1-11 (Family: none) | 1-21 |
| A | JP 2006-29834 A (HITACHI, LTD.) 02 February 2006, claims 1-12, paragraphs [0010], [0015] & US 2006/0290564 A1, claims 1-12, paragraphs [0009], [0015] & EP 1617234 A1 | 1-21 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H09100363 A
- JP 2012101438 A
- JP 2001081225 A
- JP 2002146085 A